# EUROPEAN PATENT APPLICATION

(11) **EP 2 924 719 A1**
(43) Date of publication of application: **30.09.2015**
(21) Application number: 14161566.6
(22) Date of filing: 25.03.2014
(51) Int. Cl.: H01L 21/60, H01L 23/373, H01L 25/07

(54) **Method of manufacturing a power semiconductor device using a temporary protective coating for metallisation**

(71) Applicant: ABB Technology AG, 8050 Zürich (CH)
(72) Inventor: Sivasubramaniam, Venkatesh, 8904 Aesch (CH); Guillon, David, 8857 Vorderthal (CH); Hajas, David, 5102 Rupperswil (CH); Sueltmann, Peter, 5400 Baden (CH)
(74) Representative: ABB Patent Attorneys

(57) **Abstract**

The present invention relates to a method for generating a power semiconductor module (14) using a heat applying joining technique for joining two joining partners (10, 16), the heat applying joining technique comprising the steps of:
a) Providing a first joining partner (16) with a joining surface;
b) Coating the joining surface of the first joining partner (16) at least partly with a protection coating (22), the protection coating (22) having a decomposition temperature t₁ at which the material of the protection coating (22) goes into the gaseous phase;
c) Optionally applying a joining material (23) to at least a part of the protection coating (22) or to a joining surface of the second joining partner (16); and
d) Joining the joining surfaces of the two joining partners (10, 16) by applying heat with a temperature t₂, wherein t₂ ≥ t₁ and by optionally applying pressure to the joining partners (10, 16).

One of the first and second joining partners (10, 16) is a substrate (10) and the further of the first and second joining partners (10, 16) is a power semiconductor device (16), a baseplate or a terminal. The heat applying joining technique may be a sintering process, a soldering process or an ultrasonic welding process.

Such a method provides an especially gentle and cost-saving method for heat applying joining techniques, such as die-attachment.

## Description

### Technical Field

The present invention relates to power semiconductor modules. The present invention particularly refers to an improved method of generating a power semiconductor module allowing gentle conditions and further being especially cost-saving.

### Background Art

In production of high power semiconductor modules, traditionally soldering has been used as a conventional die-attach technique. Even though soldering is appropriate for some applications, high homologues temperature with its limited thermal conductivity of typical lead-rich or tin-rich solder materials limits the thermal cycling capabilities and thus may under circumstances require alternatives for specific applications. To improve the reliability, further sintering using silver particles in a silver paste is well known as alternative die-attach technology. However a stringent prerequisite for the joining partner is a noble metallization, typically gold or silver, as the bonding is based on atomic diffusion. Inexpensive metallization such as copper are prone to oxidation even at room temperature that restricts their use for such sinter processes.

To date there are few embodiments deploying sintering methods for die-attach, which is mainly due to high material costs based on the used sintering paste as well as the required noble metal metallization. Sintering formulation that could be used for copper directly often contain additional flux chemistries that initiates residual porosity in the sintered layer or at the interface.

Known from WO 2012/061511 A2 is a method for die-attachment of multichip and single components. Such methods may involve printing a sintering paste on a substrate or on the backside of a die. The sintering paste may comprise a metal powder having a d₅₀ range of about 0.001 to about 10 micrometers a binder, and a solvent. The metal powder may thus comprise nanoparticles, wherein the nanoparticles may be coated. With regard to the substrate, the latter may be a glass, a metal, a polymeric or a ceramic substrate.

### Disclosure of Invention

It is an object of the present invention to provide a method for generating a power semiconductor module which at least partly avoids one of the disadvantages of the prior art. It is particularly an object of the present invention to provide a method for generating a power semiconductor module which allows joining a joining partner to an ignoble metal with reduced costs within said power semiconductor module generation.

These objects are at least partly solved by a method for generating a power semiconductor module according to independent claim 1. Advantageous embodiments are given in the dependent claims.

A method for generating a power semiconductor module uses a heat applying joining technique for joining two joining partners, the heat applying joining technique comprising the steps of:
a) Providing a first joining partner with a joining surface;
b) Coating the joining surface of the first joining partner at least partly with a protection coating, the protection coating having a vaporization temperature t₁;
c) Optionally applying a joining material to at least a part of the protection coating or to a joining surface of the second joining partner; and
d) Joining the joining surfaces of the two joining partners by applying heat with a temperature t₂, wherein t₂ ≥ t₁, and by optionally applying pressure to the joining partners.

A method for generating a power semiconductor module like described above allows joining two joining partners using gentle conditions with reduced costs. In particular, the method relates to die-attaching or to joining a substrate to a baseplate or to joining a terminal foot to a substrate metallization in the field of producing power semiconductor modules.

A power semiconductor module according to the present invention shall particularly mean an arrangement which is based on one or more power semiconductor devices and which may preferably be used as a switch or rectifier in power electronics. Non-limiting examples for power semiconductor devices comprise inter alia gate turn-off thyristors (GTO), diodes, thyristors. Within the present invention power semiconductor modules are especially those who comprise a substrate with a metallization which is joined to a die, i.e. the power semiconductor device, or a chip, respectively, with its front side and/or to a baseplate with its backside and wherein the substrate metallization is connected to a terminal foot.

Further, according to the method as described above a heat applying joining technique is used for generating the power semiconductor module. This allows joining the respective joining surfaces of the joining partners with a high quality. Such heat applying joining techniques are generally known in the art. For example, such joining techniques comprise such steps in which at least one of the joining partners or a joining material provided between the joining partners is treated with elevated temperatures, such as above room temperature, in order to realize the joining step. As examples, such heat applying joining techniques may comprise soldering or sintering or ultrasonic welding.

In fact, the generated power semiconductor module generally comprises a substrate, on which substrate at least one die or power semiconductor device, respectively, is located. The substrate may generally be any substrate known in the art for power semiconductor modules. For example, the substrate may be formed of an insulating material, such as of a ceramic material. As non-limiting examples, the substrate may be formed from aluminium nitride (AlN), silicon nitride (Si₃N₄) or aluminium oxide (Al₂O₃). On the surface of the front side of the substrate, a plurality of circuit paths may be provided like generally known in the art. Such circuit paths may for example be formed from a metallization, such as from a copper metallization. The metal, such as the copper, may be arranged on the substrate by physical or chemical deposition methods, for example, like it is generally known in the art.

In order to generate the power semiconductor module, thus, a die is joined to the substrate via its substrate metallization and a terminal foot is joined to the substrate via its substrate metallization.

Further, in order to remove heat generated in the power semiconductor module, or especially in the power semiconductor device, the substrate may be connected to a baseplate. The baseplate is often formed from an ignoble metal, such as of copper or AlSiC both of which may be coated with nickel, for example, and may act as a heat sink thereby effectively removing heat form the circuit paths. Further, the substrate may be coated with an ignoble metal, such as copper, at the area where the baseplate is joined to.

As a result, the joining partners provided in the present invention preferably are the substrate with its substrate metallization and a die, for example a chip or a power semiconductor device, respectively or a terminal, or a baseplate, respectively. In detail, a die and/or a terminal is joined to the front side of the substrate, or the substrate metallization, respectively, and the baseplate is joined to the backside of the substrate.

According to the above, the present method firstly comprises as step a) the step of providing a first joining partner with a joining surface like described above. For example, the first joining partner with its joining surface may be the substrate with its front side, i.e. the substrate metallization, or it may be the backside of the substrate, the above examples not being limiting. The joining surface according to the present invention shall particularly be the area at which a further joining partner should be joined to.

According to step b) of the present method, the joining surface of the first joining partner is at least partly coated with a protection coating. It may thus be provided that the protection coating is provided only to the first joining surface or to both the first and the second joining surface. With regard to the protection coating, such a coating may be understood as a coating which protects or shields the joining partner, or its joining surface, respectively, from a negative influence due to the heat treatment of the heat applying joining method. For example, the protection coating may prevent the joining surface to be oxidized due to the heat influence of the heat applying joining technique and the presence of oxygen in ambient air.

It is thus apparent that the specific joining surface the protection coating is applied to is strongly dependent from the properties of the joining partners to be joined. For example, in case a substrate provided with a substrate metallization is joined to a die in the field of die-attaching or to a terminal, particularly the substrate metallization as joining surface may be coated and thus protected. In detail, the substrate may especially be coated in the area of the substrate metallization. In other words, it may be provided that the substrate is fully coated with said protection coating, or it may be provided that only defined areas of the substrate are coated with the respective protection coating, such as particularly the areas of the substrate metallization. It may be preferred that at least the whole substrate metallization is coated with the protection coating. In case the substrate is joined to a baseplate, however, it may be provided that the protection coating is applied to the baseplate which often is formed from an ignoble metal or metal matrix composited coated with ignoble metal and is thus preferably protected. Further or additionally, it may be provided that the baseplate is coated with the protection coating especially in cases where the backside of the substrate as well comprises a metallization such as formed from in ignoble metal, such as copper. It may thereby be provided that the whole baseplate or backside of the substrate is coated or only defined areas thereof are coated, such as the joining surface.

With regard to the protection coating used, the latter further has a vaporization temperature t₁. The vaporization temperature t₁ may particularly be the temperature at which the protection coating decomposes and is thus preferably fully removed from the coated joining surface such as from the substrate metallization or the baseplate, for example. As an example, the material of the protection coating is decomposed such, that it is transferred into a gaseous state and is thus easily and particularly fully removed from the respective surface and thus allows a high quality connection of the respective joining partners, like will be described in more detail down below. However, the term "vaporization temperature" should be understood as a temperature at which independent from the specific mechanism, the material of the protection coating goes into the gaseous phase and is thus removed from the surface which was coated therewith.

According to the present method and particularly according to step c) of the method as described, subsequently a joining material may be applied to at least a part of the protection coating or to a joining surface of the second joining partner. According to this step, a material which connects the joining partners to be joined, or their respective joining surfaces, respectively, is applied. For example, the joining material may be applied to the whole protection coating. As a non-limiting example, the whole metallization being covered with the protection coating may be provided with said joining material, whereas the further surface of the front side of the substrate such as of the ceramic base material of the substrate may not be provided with the joining material, or the die to be joined may be provided with the joining material. Further, the joining material may be applied to the whole baseplate or the whole backside surface of the substrate. It is, however, preferred that only the respective defined joining surfaces are provided with said joining material in case it is required. The above examples, however, are not limiting.

With regard to the joining material, this may particularly be such a material which is placed between the respective joining partners and which may cause or improve the joining strength of the respective joining partners, respectively, during the following high temperature joining technique.

After having optionally applied the joining material, the respective joining partners may be arranged and aligned such that they may be joined together. Particularly, they may be brought in contact to each other. Further, according to step d) of the present method, the joining surfaces of the two joining partners are joined by applying heat with a temperature t₂. Thus, a heat applying joining technique is used. According to this, heat is applied to the joining partners and/or to the joining material, wherein under circumstances additionally a pressure may be exerted. The temperature used is thereby particularly dependent from the joining partners used and especially from the joining material provided. It is, however, important that the temperature used is at least equal or preferably higher than the vaporization temperature of the protection coating, i.e. that t₂ ≥ t₁. This method has significant advantages over joining methods known in the prior art especially with regard to die-attaching techniques.

According to the present method, the protection coating protects the respective joining partner and thus prevents a negative influence thereto. For example, an oxidation of the respective joining partner may be prevented. Therefore, it is securely prevented that the joining partners are negatively influenced by the heat applied and the atmosphere surrounding the joining partner, such as ambient air.

The protection coating however, may thereby be provided especially cost-saving as a plastic coating or organic coating, respectively, may be applied instead of providing a further metallization formed from noble metals such as gold or silver as known from the prior art for die attaching, for example. With this regard, the present method allows an improved route for joining a component on instable joining partners, such as on copper, that allows significant price reduction. Therefore, an effective protection especially with regard to oxidation may be provided being especially cost-saving.

With regard to cost-efficiency and especially with regard to omitting expansive noble metal metallizations as described above, the latter may result in less than ¼ of the costs for the protection coating, wherein the values provided are only descriptive and in no way limiting.

Currently for demonstration purpose a conformal electronic high-tech coating as protection coating was used. These coatings can be dip coated and cure rapidly at room temperature to form a fine homogenous coating for example having a thickness of approximately 10 to 100 nm.

The process route for the organic coating as protection coating instead of providing a further metallization, for example, is extremely simple, straight forward and robust. Therefore the process costs are very reasonable.

It is also possible that the joining partner provided with a protection coating is preformed such as by a dip coating process, for example, wherein the so produced joining partner is stored before it is processed further. This will allow using a joining partner, such as substrate, that could be directly processed further and which is insusceptible for oxidation during the storage time.

Further, due to the fact that the joining method is performed at a temperature which is equal or over the vaporization temperature of the protection coating, the latter will preferably fully decompose and will thus be removed. This allows a defined and high quality connection of the respective joining partners.

Especially, in case only defined areas of the substrate are coated with the protection coating, the respective coating material may be vaporized and removed during step d) especially easily and fast. However, it is clear from the afore-mentioned description that the present invention is not limited to this embodiment but works without problems even in case the whole substrate is coated with the protection coating.

To summarize, the present method provides a joining method for joining two joining partners in the process of power semiconductor device generation which is especially cost-saving and gentle.

According to an embodiment, the protection coating has a vaporization temperature t₁ in the range of 150 to 300°C. Especially according to this embodiment, the vaporization temperature is low enough in order to allow typical heat applying technologies to be applied without negatively influencing their effectivity. Further, it is effectively secured that the protection coating is removed completely during the joining process which in turn secures a high quality connection especially with regard to electrical conductivity and heat cycling properties.

According to a further embodiment, the protection coating comprises an organic material which is selected from the group consisting of polyvinylpyrrolidone, thiols, amines, amine derivatives, fluoropolymers, imidazole, imidazole derivatives, benzotriazole, benzotriazole derivatives, silane and silane derivatives. Especially the afore-named materials are well suited for protecting the respective joining partners such as an ignoble metal, for example copper, aluminum or their alloys. Further, these polymers may be removed by vaporization by using gentle temperatures allowing gentle joining conditions which allow preventing deteriorating the joining partners. Especially preferred are fluoropolymers. In fact, it may be secured that the above materials fully vaporize and are thus removed, allowing a high quality connection.

According to a further embodiment, the protection coating has a thickness in the range of ≥ 10 to ≤ 1000nm. In case the protection coating has a thickness in the above-defined range, the latter may securely protect the respective joining partner and may further be decomposed and thus removed from the surface completely. According to this, especially the afore-named thicknesses of the protection coating may allow gentle joining conditions and further allow a high quality joining result.

According to a further embodiment, the heat applying joining technique is a sintering process and the joining material is a sintering material. According to this embodiment, the joining partners and thus the respective joining surfaces thereof are connected to each other via a sintering process. This embodiment may be especially preferred in case one of the joining partners is a substrate provided with a substrate metallization, such as formed from copper, and the further joining partner is a die, such as a chip or a power semiconductor device, respectively. Accordingly, this embodiment is especially preferred for die-attachment. With regard to the protection coating, the latter may be provided on the substrate metallization.

A sintering process as it is known in the art generally comprises bringing the joining partners in contact to each other by use of a sintering material, such as a sintering paste, and joining the respective components accordingly.

With regard to the sintering material, it may be preferred that the sintering material comprises metal nanoparticles or metal microparticles. The material of the nanoparticles may be chosen in dependence of the present application and may, for example, comprise silver, gold, copper, palladium and aluminum or mixtures or alloys comprising at least one of the afore-described materials. It is, however, especially preferred that the metal nanoparticles comprise silver. The metal particles further may have a diameter in the range of ≥ 20 nm to ≤ 100 nm, particularly ≥ 20 nm to ≤ 40 nm, for the example of nanoparticles or in the range of for example ≥ 100nm to ≤ 100µm in case microparticles are used, wherein the afore-named values are not limiting.

Especially using nanoscale particles may be advantageous due to the fact that such particles facilitate lower process parameters. In general, lower process parameters are beneficial for lower thermal stress in the joint assembly after cooling to room temperature, i.e. after finishing the heat applying joining technique. According to this, by using nanoscale particles, for example, low temperature bonding (LTB) may be used.

These materials may be used uncoated or coated, or capped, respectively, particularly with an organic coating. The organic coating may be the same as described above with regard to the protection coating, or it may be a different coating. With this regard, less surface oxidation is obtained as the coating protects the individual particles until the vaporization temperature of the organic cap, which may typically lie in a range of 150-300°C, such as 150-180°C.

The metal nanoparticles or the metal microparticles may further be present in a foil, an ink or a paste, for example. In the latter case, the sintering paste used as joining material may comprise, next to the metal nanoparticles, a solvent and a binder, as it is generally known in the art. Therefore, generally any sintering material known as such may be used as joining material.

Especially the afore-named parameters may allow sintering with very gentle conditions, i.e. by applying a low temperature and a low pressure. For example, the joining process may be applied by use of a pressure of several MPa, such as 5 to 50 MPa pressure when pressing the joining partners against each other and a temperature in a range of 230 to 300°C and thus by applying pressure and heat. Therefore, low temperature sintering may be used which additionally helps preserving the joining partners during the heat applying joining technique.

Further, the sintering material may provide a very narrow particle size distribution and may cause low agglomeration resulting in an essentially void free connection and thus a connection having a high quality with regard to temperature cycling end electrical conductivity.

To summarize, a very high sintering density may be achieved and thus products having a very high quality may be produced when performing a sintering process as described above.

According to a further embodiment, the heat applying joining technique is a soldering process and the joining material is a solder. This embodiment is especially preferred for joining a baseplate to the substrate and particularly to the backside of the latter. With regard to the protection coating, the latter may be provided on the baseplate or on the backside of the substrate and particularly on a respective substrate metallization.

Soldering according to the present invention may thereby be generally a process in which two joining partners are joined together by a molten flowable soldering material which hardens after the soldering step and thus forms a stable connection. It is thus preferred that the soldering material has a lower melting point than the components to be soldered, or joined, respectively. The soldering material, or the solder, respectively, may thus be formed from a particularly low melting material as it is generally known in the art. As non-limiting examples, the soldering material may be formed of lead, or may preferably be formed from lead-free materials. However, generally any material such as meltable alloys which melt in an appropriate range such as below 360°C, preferable below 300°C, but as well in a range over 450°C may be used.

It may be preferred that the soldering material is chosen from the group consisting of, lead (Pb), tin (Sn), silver (Ag), antimony (Sb), gold (Au), germanium (Ge), indium (In), bismuth (Bi), copper (Cu) or a mixture or an alloy including at least one of the afore-mentioned compounds, such as in a non-limiting example SnPb, SnSb, AuSn, AuGe, In, InPb, InAg, InSn, BiSn, SnAg, PbSnAg, PbInAg, or SnAgCu. Especially the afore-mentioned compounds may secure that the material may melt under appropriate conditions and may further allow good wetting properties. As a result, an especially reliable solder connection may be formed according to this embodiment

Like described above, the soldering process may be used for soldering a substrate, such as a ceramic substrate, to a baseplate. Like described above, the baseplate may act as a heat sink and may thus be formed form a metal as it is generally known in the art. The usage of a soldering technique thereby allows an efficient and economic connection process thereby allowing a stable and reliable connection of the respective components, such as for example the baseplate and the substrate.

The soldering process may be used in a reducing atmosphere such as in formic gas, forming gas, i.e. a mixture of formic acid and nitrogen, hydrogen or ammonia. Especially the afore-named reducing gases can especially effectively prevent voids between the components to be soldered and the solder and a mechanically stable and electrically and thermically conductive connection can be established without the use of any flux additional to the reducing atmosphere. However, as there is no risk of oxidation of the joining partner due to the protection coating provided, it is not required to remove a formed oxide layer of the object to be soldered when coming in contact to the latter due to the reducing gas. Therefore, a reducing atmosphere may be omitted and the used atmosphere may be an inert gas, such as argon or nitrogen, a vacuum or even air.

According to a further embodiment, the heat applying joining technique is an ultrasonic welding process. According to this embodiment, a terminal, or a terminal foot, respectively, may be welded to the substrate metallization, such as the copper metallization. With this regard the protection coating may be provided to one or both of the terminal foot or the metallization. According to this embodiment, no joining material has to be applied as the joining partners plastically deform to form the joint. Referring to this, heat may be applied together with ultrasonic vibrations in order to form the connection as it is generally known in the art, as a non-limiting example both of the terminal foot and the substrate metallization may be formed from copper, a copper-copper bond may be formed. With regard to the protection coating, the latter may be provided on the substrate metallization or on the terminal, or the terminal foot, respectively.

According to this embodiment, especially when providing a terminal which is preformed with the protection coating, the cleaning steps of the terminal foot, for example, which often is provided in order to remove oxidations, may be omitted which allows the method to be more fast and cost-saving. Further, a terminal foot being provided with a protection coating may allow a package with fewer requirements.

According to a further embodiment, in step e) a temperature t₂ in the range of ≥ 170 to ≤ 360 is used, wherein soldering may be performed in a temperature in the range of 170 to 360°C, whereas sintering may be performed in a range of 230 to 300°C and wherein the temperature induced by ultrasonic welding, such as by applying ultrasonic radiation, may as well lie above the respective vaporization temperature of the protection coating. Especially according to this embodiment, it may be ensured that the protective coating both of the joining partner as well as optionally of the metal particles of the sintering material, for example, are completely decomposed and removed which in turn allows a connection having an especially high quality. Apart from that, these temperatures are low enough in order not to deteriorate the joining partners.

According to a further embodiment, step e) is performed in a reducing atmosphere, an inert atmosphere air, or a vacuum. Especially the above-named atmospheres may result in a high quality connection, may be cost-saving and may allow an economical process.

### Brief Description of Drawings

These and other aspects of the invention will be apparent from and elucidated with reference to the embodiments described hereinafter.

In the drawings:
- Fig. 1: shows an exemplary embodiment of a substrate provided with a copper metallization which may act as a joining partner in the method according to the invention;
- Fig. 2: shows a produced power semiconductor module;
- Fig. 3: shows a step of an embodiment of the method according to the invention; and
- Fig. 4: shows a further step of an embodiment of the method according to the invention.

### Detailed Description of the Invention

Reference will now be made in detail to various embodiments, one or more examples of which are illustrated in each figure. Each example is provided by way of explanation and is not meant as a limitation. For example, features illustrated or described as part of one embodiment can be used on or in conjunction with other embodiments to yield yet further embodiments. It is intended that the present disclosure includes such modifications and variations.

Within the following description of the drawings, the same reference numbers refer to the same components. Generally, only the differences with respect to the individual embodiments are described. When several identical items or parts appear in a figure, not all of the parts have reference numerals in order to simplify the appearance.

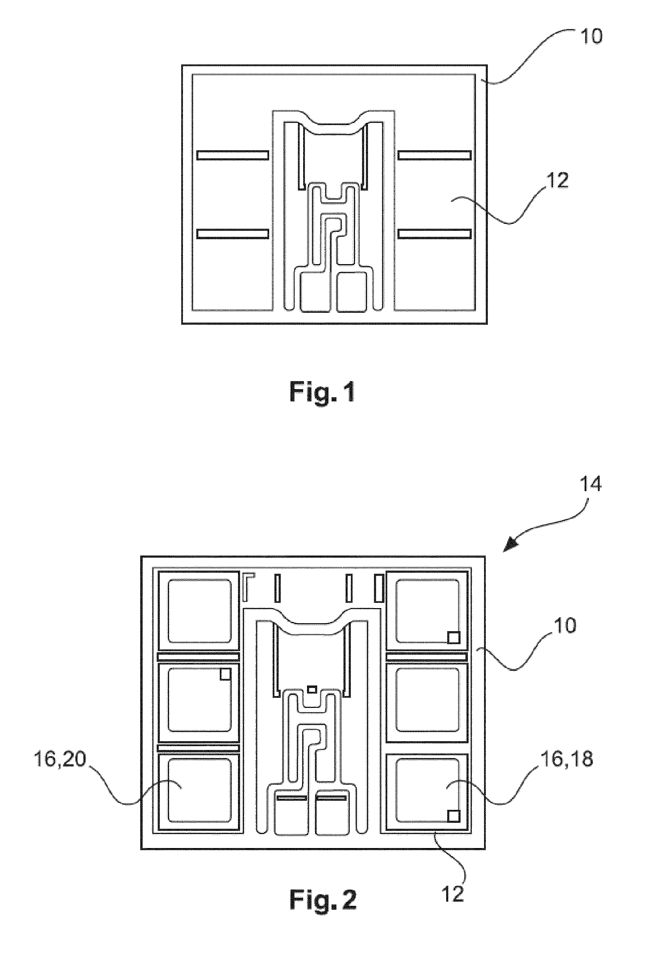

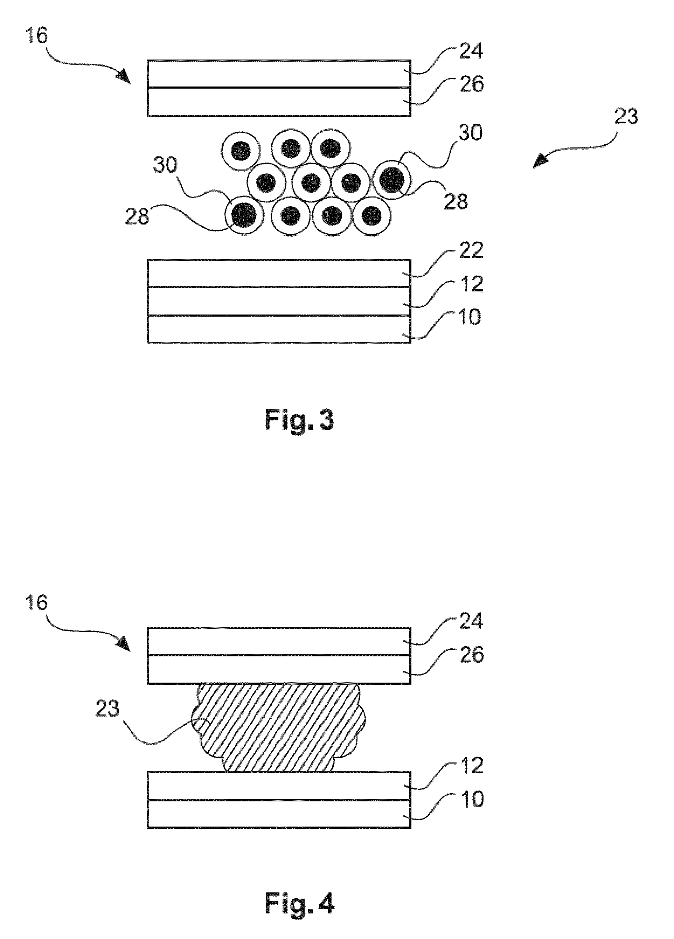

Figure 1 shows an embodiment of a substrate 10 provided with a copper metallization 12 which may act as a joining partner in the method according to the invention. The metallization 12 or the whole substrate 10 may form a joining surface to be joined with a further joining partner. This is shown in detail in figures 3 and 4 like will be apparent down below.

Figure 2 shows a power semiconductor module 14 which is produced according to the present invention. It is shown that the metallizations 12 are joined with a power semiconductor device 16, such as an IGBT 18 or a diode 20.

According to the present method and like shown in figures 3 and 4, firstly, the joining surface of the first joining partner, i.e. of the substrate 10 or the substrate metallization 12, respectively is at least partly provided with a protection coating 22. The protection coating 22 has a vaporization temperature t₁, which preferably lies in a range of 150 to 300°C.

After having applied the protection coating 22 as described above, such as by using dip coating, jet coating, spray coating, or the like, a joining material 23 is applied to at least a part of the protection coating 22 or to a joining surface of the second joining partner. According to the embodiment of figure 2, a sintering material may be applied to the surface of the copper metallization 12. The joining material 23, or the sintering material, respectively, may particularly comprise metallic nanoparticles 28 which are provided with an organic coating 30.

As an example, a similar organic cap material could be used as coating 30 as well as for forming a protection coating 22 so as to prevent premature oxidation while reaching the sinter temperature. This preserves the copper surface in its pristine condition until the protection coating vaporizes at temperature between exemplarily 200-250°C. It is further hypothesized that the protection coating 22 helps to synchronize the intimate contact of the sinter material and especially the silver nanoparticles 28 to the copper surface before oxidation could hinder the sintering process and could thus act as an oxidation barrier.

In other words, the protection coating 22 is rendered via simple dip coat process with commercially available plastic materials, which may comprise fluoropolymers. It could be seen that the protection coating 22 disintegrates directly into a vapour phase around 200-250°C without visible carbon residues. Both the joining partners may be pre-cleaned, for example with 15% HCl and rinsed with ethanol.

Referring back to figure 3, this figure shows the arrangement of both joining partners before the sintering process. The first joining partner comprises the substrate 10 comprising the substrate metallization 12 covered by the protective coating 22. The further joining partner comprises a power semiconductor device 16 with a silicon layer 24 and a silver metallization 26.

The sintering process may be performed with elevated temperatures and elevated pressures such that the coating 30 as well as the protection coating 22 will be decomposed and removed and thus a stable connection is provided like shown in figure 4, wherein the joining material comprises only the metal of the respective nanoparticles 28 as the material of the coating is vaporised.

While the invention has been illustrated and described in detail in the drawings and foregoing description, such illustration and description are to be considered illustrative or exemplary and not restrictive; the invention is not limited to the disclosed embodiments. Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

- 10: Substrate
- 12: Metallization
- 14: Power Semiconductor Module
- 16: Power Semiconductor Device
- 18: IGBT
- 20: Diode
- 22: Protection Coating
- 23: joining material
- 24: silicon layer
- 26: metallization
- 28: nanoparticle
- 30: coating

## Claims

1. Method for generating a power semiconductor module (14) using a heat applying joining technique for joining two joining partners, the heat applying joining technique comprising the steps of:
a) Providing a first joining partner with a joining surface;
b) Coating the joining surface of the first joining partner at least partly with a protection coating (22), the protection coating (22) having a vaporization temperature t₁;
c) Optionally applying a joining material (23) to at least a part of the protection coating (22) or to a joining surface of the second joining partner; and
d) Joining the joining surfaces of the two joining partners by applying heat with a temperature t₂, wherein t₂ ≥ t₁ and by optionally applying pressure to the joining partners.

2. Method according to claim 1, wherein one of the first and second joining partners is a substrate (10) and wherein the further of the first and second joining partners is a power semiconductor device (16), a baseplate or a terminal.

3. Method according to claim 1 or 2, wherein the protection coating has a vaporization temperature t₁ in the range of 150 to 300°C.

4. Method according to any of the preceding claims, wherein the protection coating (22) comprises an organic material which is selected from the group consisting of polyvinylpyrrolidones, thiols, amines, amine derivates, imidazole, imidazole derivates, benzotriazole, benzotriazole derivates, silane, silane derivates or fluoropolymers.

5. Method according to any of the preceding claims, wherein the protection coating (22) has a thickness in the range of ≥ 10 to ≤ 1000nm.

6. Method according to any of the preceding claims, wherein the heat applying joining technique is a sintering process and wherein the joining material (23) is a sintering material.

7. Method according to claim 6, wherein the sintering material comprises metal nanoparticles (28) or metal microparticles.

8. Method according to any of claims 1 to 5, wherein the heat applying joining technique is a soldering process and wherein the joining material (23) is a solder.

9. Method according to claim 8, wherein the soldering material is chosen from the group consisting of, lead, tin, silver, antimony, gold, germanium, indium, bismuth, copper or a mixture or an alloy including at least one of the afore-mentioned compounds.

10. Method according to any of claims 1 to 5, wherein the heat applying joining technique is an ultrasonic welding process.

11. Method according to any of the preceding claims, wherein in step e) a temperature t₂ in the range of 170 to 360°C is used.

12. Method according to any of the preceding claims, wherein step e) is performed in a reducing atmosphere, an inert atmosphere air, or a vacuum.
